Europäisches Patentamt

European Patent Office

Office européen des brevets

(19)

(11) EP 0 933 643 A1

(12) **EUROPÄISCHE PATENTANMELDUNG**

(43) Veröffentlichungstag:
04.08.1999 Patentblatt 1999/31

(51) Int Cl.⁶: **G01R 31/08, H02H 3/38**

(21) Anmeldenummer: 99890031.0

(22) Anmeldetag: 29.01.1999

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: 02.02.1998 AT 17098

(71) Anmelder: **Trench Austria GmbH**
**4060 Leonding (AT)**

(72) Erfinder:
• **Druml, Gernot, Dipl.-Ing.**
**4203 Altenberg (AT)**

• **Kugi, Andreas, Dr.**
**4040 linz (AT)**
• **Papp, Klaus, Dipl.-Ing.**
**4040 Linz (AT)**

(74) Vertreter: **Weiser, Andreas, Dip.-Ing. et al**
**Patentanwälte Schütz u.Partner,**
**Schottenring 16,**
**Börsegebäude**
**1010 Wien (AT)**

(54) **Verfahren zur Fehlerortung in Drehstromnetzen**

(57)     Verfahren zum Bestimmen eines fehlerbehafteten Knotens $K_f$ in einem Drehstromnetz mit zwei Meßstellen A und B, zwischen denen Leitungsabschnitten $L_i$ liegen, mit den Schritten:

-   Messen der Nullspannungen und der Nullströme $\hat{\imath}_{1,A}$ an den Meßstellen A und B im Laplacebereich, Fourierbereich od.dgl.;
-   Berechnen einer ersten Folge von Nullspannungen und Nullströmen an jedem Knoten $K_i$ anhand der Meßwerte der Meßstelle A;
-   Berechnen einer zweiten Folge von Nullspannungen und Nullströmen an jedem Knoten $K_i$ anhand der Meßwerte der Meßstelle B;
-   Berechnen einer Differenzspannungsfolge aus erster und zweiter Nullspannungsfolge; und
-   Aufsuchen des Minimalwertes $\Delta\hat{u}_{min}$ der Folge und Anzeigen des Index min als Index f des fehlerbehafteten Knotens $K_f$.

Fig. 1

**Beschreibung**

Die vorliegende Erfindung betrifft die Erdschluß- bzw. Phase/Phase-Fehlerortung in Drehstromnetzen. Genauer befaßt sich die Erfindung mit der Ortung von Fehlern auf Abgängen, die für Messungen von beiden Enden her zugänglich sind und deren Leitungsparameter zumindest abschnittsweise bekannt sind, so daß jeder Leitungsabschnitt $L_i$ durch seine (Nullsystem- oder Mitsystem-) Mehrtorbeschreibungsmatrix $A_i$ beschrieben werden kann.

Unter der Mehrtorbeschreibungsmatrix $A_i$ eines Leitungsabschnittes wird in der vorliegenden Beschreibung jedes in der Mehrtortheorie bekannte Beschreibungsmodell zur Darstellung eines Leitungsabschnittes verstanden, sei es die Kettenmatrix, die Impedanzmatrix, die Admittanzmatrix, die Hybridmatrix, die inverse Hybridmatrix, die Streumatrix, die inverse Streumatrix usw.

In ihrer allgemeinsten Form befaßt sich die Erfindung mit der Bestimmung desjenigen Knotens $K_f$ zwischen zwei Leitungsabschnitten, welcher selbst fehlerbehaftet ist oder dessen angrenzender Leitungsabschnitt den Erdschluß- oder Phase/Phase-Fehler führt. In weiterer Folge beschäftigt sich die Erfindung auch mit der genauen Lokalisierung des Fehlers in dem als fehlerhaft ermittelten Leitungsabschnitt.

Verfahren zur Fehlerortung, welche zwei Meßpunkte im Netz ausnützen, sind bekannt. Eine Gruppe basiert auf dem Prinzip der Messung der beim Erdschluß entstehenden transienten Vorgänge an den zwei Punkten im Netz. Nachteile dieser Verfahren sind, daß sie grundsätzlich nur bei sehr niederohmigen Erdschlüssen funktionieren (< 100 Ohm), lediglich transiente Informationen liefern, die mit hohen Abtastraten aufgezeichnet werden müssen, und überdies durch die in verzweigten Netzen auftretenden Reflexionen irritiert werden können. Eine andere Gruppe von bekannten Verfahren arbeitet stationär; diese Verfahren haben den Nachteil, daß sie ebenfalls nur bei niederohmigen Erdschlüssen funktionieren, viele - häufig nicht zutreffende - Annahmen voraussetzen und überdies Referenzmessungen vor dem Fehlereintritt erfordern.

Die Erfindung setzt sich zum Ziel, ein Verfahren der eingangs genannten Art zu schaffen, das auch bei hochohmigen Erdschlüssen (soferne sie klein gegenüber den natürlichen Unsymmetrien des Netzes sind) zuverlässig arbeitet und gegenüber Reflexionen in verzweigten Netzen unempfindlich ist. Ein alternatives, jedoch damit zusammenhängendes Ziel ist die Schaffung eines derartigen Verfahrens für die Ortung von Phase/Phase-Fehlern unter der Annahme, daß der Fehlerwiderstand klein ist gegenüber angeschlossenen Verbraucherwiderständen.

Zur Erreichung dieses Zieles schafft die Erfindung ein Verfahren zum Bestimmen desjenigen Knotens $K_f$ aus einer Abfolge von Knoten $K_2..K_N$, die zwischen aufeinanderfolgenden, in einem Drehstromnetz zwischen zwei Meßstellen $A=K_1$, $B=K_{N+1}$ liegenden und die Nullsystem-Mehrtorbeschreibungsmatrizen $A_1..A_N$ aufweisenden Leitungsabschnitten $L_1..L_N$ liegen, welcher mit einem Erdschluß behaftet ist oder neben einem erdschlußbehafteten Leitungsabschnitt liegt, das sich auszeichnet durch die Schritte:

-    Messen der Nullspannung $\hat{u}_{1,A}$ und des Nullstromes $\hat{i}_{1,A}$ an der Meßstelle A sowie der Nullspannung $\hat{u}_{N+1,B}$ und des Nullstromes $\hat{i}_{N+1,B}$ an der Meßstelle B im Laplacebereich, Fourierbereich od.dgl.;
-    Berechnen einer ersten Folge von Nullspannungen $\hat{u}_{i,A}$ und Nullströmen $\hat{i}_{i,A}$ an jedem Knoten $K_i$ von der Meßstelle A aus gesehen, anhand der Meßwerte $\hat{u}_{1,A}$ und $\hat{i}_{1,A}$ und der Mehrtorbeschreibungsmatrizen $A_1...A_N$;
-    Berechnen einer zweiten Folge von Nullspannungen $\hat{u}_{i,B}$ und Nullströmen $\hat{i}_{i,B}$ an jedem Knoten $K_i$ von der Meßstelle B aus gesehen, anhand der Meßwerte $\hat{u}_{N+1,B}$ und $\hat{i}_{N+1,B}$ und der Mehrtorbeschreibungsmatrizen $A_1...A_N$;
-    Berechnen einer Differenzspannungsfolge $\Delta\hat{u}_i$ aus erster und zweiter Nullspannungsfolge; und
-    Aufsuchen des Minimalwertes $\Delta\hat{u}_{min}$ der Differenzspannungsfolge und Anzeigen des Index min als Index f des fehlerbehafteten oder neben einem fehlerbehafteten Leitungsabschnitt liegenden Knotens $K_f$.

Bei exakten Leitungsparametern und wenn keine Meßfehler bei der Messung der Nullspannungen und Nullströme in den Meßstellen auftreten, ist $\Delta\hat{u}_{min}$ gleich Null, wenn der Fehlerort im Knoten liegt.

Das erfindungsgemäße Verfahren beruht auf dem neuartigen Ansatz, daß die - eine erfolgreiche Modellierung der Leitung bzw. des Netzes durch eine Abfolge von Übertragungsfunktions-bzw. Mehrtorbeschreibungsmatrizen für das Nullsystem vorausgesetzt - ausgehend von einem Ende für jeden Knoten bis zur Fehlerstelle berechneten Nullspannungen und Nullströme der Realität entsprechen, jedoch ab der Fehlerstelle auf Grund des über die Fehlerstelle abfließenden Erdschlußstromes von der Realität abweichen, u.zw. in zunehmendem Maße bis zum anderen Ende der Leitung. Die Berechnung der Nullströme und Nullspannungen für jeden Knoten ausgehend vom anderen Ende der Leitung ergibt dasselbe Bild, d.h. eine Übereinstimmung mit der Realität bis zur Fehlerstelle und eine zunehmende Abweichung darüber hinaus. Die Differenz der beiden Folgen hat daher genau am fehlerbehafteten Knoten bzw. im Bereich des fehlerbehafteten Leitungsabschnittes ein Minimum.

Das Verfahren funktioniert selbst bei hochohmigen Erdschlüssen, soferne diese klein gegenüber den natürlichen Unsymmetrien des Netzes sind. Der Erdschlußwiderstand kann sich sogar während der Messung ändern, soferne an beiden Meßstellen gleichzeitig gemessen wird.

Das erfindungsgemäße Verfahren läßt sich auch zur Ermittlung von mehrphasigen Erdschlüssen einsetzen, vorausgesetzt, diese treten am selben Ort auf, oder aber der (örtlich beabstandete) Erdschluß der zweiten Phase geht gegen die Erde eines anderen Abganges.

Das Verfahren läßt sich auch bei Netzen anwenden, die aus unterschiedlichsten Leitungsabschnitten zusammengesetzt sind, beispielsweise aus verschiedensten Freileitungs- und Kabeltypen.

Bevorzugt sind die Mehrtorbeschreibungsmatrizen die Kettenmatrizen der Leitungsabschnitte und

- das Berechnen der ersten Folge von Nullspannungen $\hat{u}_{i,A}$ und Nullströmen $\hat{\imath}_{i,A}$ erfolgt anhand Formel:

$$\begin{bmatrix} \hat{u}_{i,A} \\ \hat{\imath}_{i,A} \end{bmatrix} = A_{i-1}^{-1} \ldots A_2^{-1} A_1^{-1} \begin{bmatrix} \hat{u}_{1,A} \\ \hat{\imath}_{1,A} \end{bmatrix} \qquad \mathtt{i\ =\ 2..N+1;}$$

und

- das Berechnen der zweiten Folge von Nullspannungen $\hat{u}_{i,B}$ und Nullströmen $\hat{\imath}_{i,B}$ erfolgt anhand der Formel:

$$\begin{bmatrix} \hat{u}_{i,B} \\ \hat{\imath}_{i,B} \end{bmatrix} = A_i \ldots A_{N-1} A_N \begin{bmatrix} \hat{u}_{N+1,B} \\ \hat{\imath}_{N+1,B} \end{bmatrix} \qquad \mathtt{i\ =\ 1..N.}$$

Die Verwendung von Kettenmatrizen ermöglicht eine besonders einfache Durchführung des Verfahrens.

Eine besonders vorteilhafte Variante des Verfahrens gemäß der Erfindung besteht darin, auch die bei der Messung der Nullströme auftretenden Meßfehler der Meßwandler und/oder Ungenauigkeiten in der Angabe der Leitungsparameter, z.B. der Kettenmatrizen, zu berücksichtigen bzw. zu kompensieren. Diese Variante des erfindungsgemäßen Verfahrens umfaßt die folgenden Schritte:

a) Bei einem ersten Arbeitspunkt I des Netzes:

- Messen der Nullspannung $\hat{u}_{1,A,I}$ und des Nullstromes $\hat{\imath}_{1,A,I}$ an der Meßstelle A sowie der Nullspannung $\hat{u}_{N+1,B,I}$ und des Nullstromes $\hat{\imath}_{N+1,B,I}$ an der Meßstelle B im Laplacebereich, Fourierbereich od.dgl.;
- Berechnen einer ersten Folge von Nullspannungen $\hat{u}_{i,A,I}$ und Nullströmen $\hat{\imath}_{i,A,I}$ an jedem Knoten $K_i$ von der Meßstelle A aus gesehen, anhand der Meßwerte $\hat{u}_{1,A,I}$ und $\hat{\imath}_{1,A,I}$ und der Mehrtorbeschreibungsmatrizen $A_1 \ldots A_N$;
- Berechnen einer zweiten Folge von Nullspannungen $\hat{u}_{i,B,I}$ und Nullströmen $\hat{\imath}_{i,B,I}$ an jedem Knoten $K_i$ von der Meßstelle B aus gesehen, anhand der Meßwerte $\hat{u}_{N+1,B,I}$ und $\hat{\imath}_{N+1,B,I}$ und der Mehrtorbeschreibungsmatrizen $A_1 \ldots A_N$;
- Berechnen einer ersten Differenzspannungsfolge $\Delta\hat{u}_{i,I}$ aus erster und zweiter Nullspannungsfolge;
- Normieren der ersten Differenzspannungsfolge $\Delta\hat{u}_{i,I}$ auf den Nullstrom an einem der Meßpunkte A oder B zur Erzeugung einer ersten Quotientenfolge $\hat{a}_{i,I}$;

b) Beeinflussen des Nullsystems des Drehstromnetzes durch eine oder mehrere der Maßnahmen: Einspeisen eines Hilfssignales in den Sternpunkt, Verstimmen der Petersen-Spule (falls vorhanden), Zuschalten einer Hilfsimpedanz zwischen Sternpunkt und Erde, od.dgl., zur Einstellung eines zweiten Arbeitspunktes II des Netzes;

c) Beim zweiten Arbeitspunkt II des Netzes:

- Messen der Nullspannung $\hat{u}_{1,A,II}$ und des Nullstromes $\hat{\imath}_{1,A,II}$ an der Meßstelle A sowie der Nullspannung $\hat{u}_{N+1,B,II}$ und des Nullstromes $\hat{\imath}_{N+1,B,II}$ an der Meßstelle B im Laplacebereich, Fourierbereich od.dgl.;
- Berechnen einer dritten Folge von Nullspannungen $\hat{u}_{i,A,II}$ und Nullströmen $\hat{\imath}_{i,A,II}$ an jedem Knoten $K_i$ von der Meßstelle A aus gesehen, anhand der Meßwerte $\hat{u}_{1,A,II}$ und $\hat{\imath}_{1,A,II}$ und der Mehrtorbeschreibungsmatrizen $A_1 \ldots A_N$;
- Berechnen einer vierten Folge von Nullspannungen $\hat{u}_{i,B,II}$ und Nullströmen $\hat{\imath}_{i,B,II}$ an jedem Knoten $K_i$ von der Meßstelle B aus gesehen, anhand der Meßwerte $\hat{u}_{N+1,B,II}$ und $\hat{\imath}_{N+1,B,II}$ und der Mehrtorbeschreibungsmatrizen $A_1 \ldots A_N$;
- Berechnen einer zweiten Differenzspannungsfolge aus dritter und vierter Nullspannungsfolge;
- Normieren der zweiten Differenzspannungsfolge auf den Nullstrom am selben der Meßpunkte A oder B wie zuvor beim Arbeitspunkt I, zur Erzeugung einer zweiten Quotientenfolge $\hat{a}_{i,II}$;

d) Berechnen einer Differenz-Quotientenfolge $\Delta\hat{a}_i$ aus erster und zweiter Quotientenfolge; und

e) Aufsuchen des Minimalwertes $\Delta\hat{a}_{min}$ der Differenz-Quotientenfolge und Anzeigen des Index min als Index f des fehlerbehafteten oder neben einem fehlerbehafteten Leitungsabschnitt liegenden Knotens $K_f$.

Die Wirkungsweise dieser Verfahrensvariante wird später noch ausführlich beschrieben. Tatsächlich werden bei diesem Verfahren allfällige Meßfehler der bei den Strommessungen verwendeten Stromwandler kompensiert. Im Anschluß an die Bestimmung des Fehlerortes können auch die Stromwandlermeßfehler berechnet werden.

In der Praxis hat sich gezeigt, daß diese Verfahrensvariante sogar in weitem Maße unempfindlich gegenüber Ungenauigkeiten der getroffenen Annahmen für die Leitungsparameter ist. Die Leitungsparameter unterliegen häufig witterungsbedingten Schwankungen, sodaß in der Praxis exakte Voraussagen gar nicht getroffen werden können. Das vorgestellte Verfahren ist auch unter diesen schwierigen Praxisbedingungen einsetzbar.

Das weitere Erfindungsziel der Ortung von Phase/Phase-Fehlern wird erreicht, wenn alles, was in der vorliegenden Beschreibung in Bezug auf das Nullsystem ausgesagt wird, auf das Mitsystem übertragen wird. Die Erfindung schafft daher auch ein Verfahren, wie es im Anspruch 5 definiert ist.

In jeder Verfahrensvariante der Erfindung kann bevorzugt vorgesehen werden, im Anschluß an die Bestimmung des fehlerbehafteten Leitungsabschnittes den genauen Fehlerort innerhalb des Leitungsabschnittes zu bestimmen, u.zw. durch den zusätzlichen Schritt des Berechnens des Fehlerortes $x_f$ ausgehend von den Nullströmen und Nullspannungen auf beiden Seiten des Leitungsabschnittes $L_f$, z.B. durch Interpolation, Lösen der Leitungsgleichungen, od.dgl.

Besonders bevorzugt wird der Fehlerort $x_f$ anhand der Gleichung

$$x_f = L - \frac{1}{\gamma}\ln\left(\pm\frac{\sqrt{-k_1 e^{\gamma L}\left(\left(u_f - Z_W i_f\right)e^{\gamma L} - \left(u_{f+1} - Z_W i_{f+1}\right)\right)}}{k_1}\right)$$

mit

$$k_1 = (u_f + Z_W i_f) - (u_{f+1} + Z_W i_{f+1})e^{\gamma L}$$

L...Leitungslänge des Leitungsabschnittes $L_f$
$Z_W$... Wellenwiderstand des Leitungsabschnittes $L_f$
$\gamma$... Wellendämpfungsmaß des Leitungsabschnittes $L_f$

$(\hat{u}_f, \hat{i}_f)$ und $(\hat{u}_{f+1}, \hat{i}_{f+1})$ ...Null- oder Mitspannung bzw. -strom
auf beiden Seiten des Leitungsabschnittes $L_f$ bestimmt.

Alle erfindungsgemäßen Verfahren sind bevorzugt auch bei verzweigten Netzen mit Leitungsmaschen und Stichleitungen anwendbar, indem diese auf eine Ersatzverbindung zwischen zwei Meßstellen reduziert werden, wie in Anspruch 8 definiert.

Weitere Merkmale und Vorteile der Erfindung werden nachstehend an Hand von Ausführungsbeispielen unter Bezugnahme auf die begleitenden Zeichnungen näher erläutert. In den Zeichnungen zeigt

Fig. 1 das Nullsystem eines typischen Drehstromnetzes mit zwei Meßstellen im Erdschlußfall,
Fig. 2 eine Kettenmatrixdarstellung des Netzes von Fig. 1, die
Fig. 3 bis 5 Darstellungen von reduzierbaren Serien-, Parallel- und Stichschaltungen von Leitungsabschnitten,
Fig. 6 eine äquivalente Kettenmatrixdarstellung der Kettenmatrix von Fig. 2,
Fig. 7 die Spannungs- und Stromverhältnisse im fehlerbehafteten Leitungsabschnitt $L_f$ und
Fig. 8 das Nullsystem eines Netzes mit drei Meßstellen.

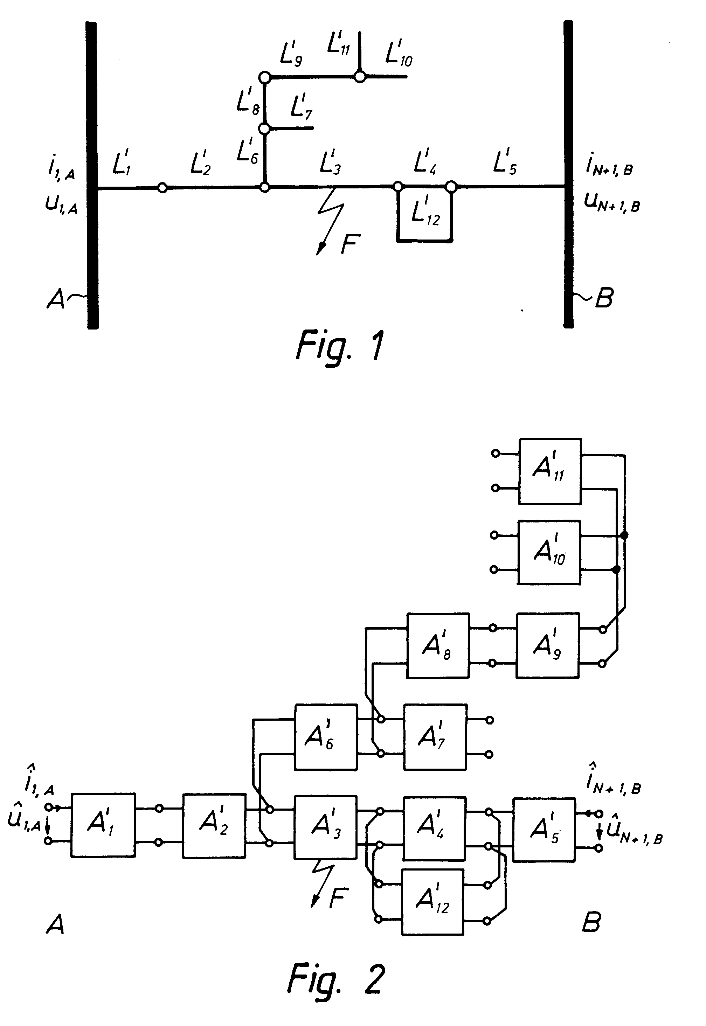

Wie allgemein bekannt, läßt sich ein Drehstromsystem nach dem Verfahren der Symmetrischen Komponenten in Ersatzschaltbilder für das Nullsystem, das Mitsystem und das Gegensystem überführen. Fig. 1 zeigt das Nullsystem eines beispielhaften Netzes mit zwei an Sammelschienen liegenden Meßstellen A, B, zwischen denen Lei-

tungsabschnitte $L_1'$ bis $L_{12}'$ liegen. Die Leitungsabschnitte können Stiche (z.B. die Leitungsabschnitte $L_6'$ bis $L_{11}'$) und Maschen (z.B. die Leitungsabschnitte $L_4'$ und $L_{12}'$) bilden. An einem Fehlerort F liegt ein einphasiger Erdschluß vor, im dargestellten Fall im Leitungsabschnitt $L_3'$.

(Die hier vorgestellten Verfahren lassen sich unter den erwähnten Voraussetzungen auch zur Ortung von mehrphasigen Erdschlüssen, von Phase/Phase-Schlüssen und von Phase/Phase-Schlüssen mit Erdberührung anwenden; für die letzteren beiden Anwendungsfälle sind in den folgenden Erläuterungen anstelle der entsprechenden Ausdrücke des Nullsystems (Nullströme, Nullspannungen, Nullsystem-Kettenmatrizen usw.) die jeweiligen Ausdrücke des Mitsystems einzusetzen.)

In den Meßstellen A und B treten jeweils der Nullstrom $i_{1,A}$ bzw. $i_{N+1,B}$ und die Nullspannung $u_{1,A}$ bzw. $u_{N+1,B}$ des zur jeweils anderen Meßstelle führenden Abganges ($L_1'$ bzw. $L_5'$) auf.

Die vorgestellten Verfahren sind auch anwendbar, wenn die Leitung zwischen den Meßstellen A und B zu einem Ring an einer einzigen Sammelschiene zusammengeschaltet ist, d.h. $u_{1,A} = u_{N+1,B}$ ist.

Für die weitere Modellierung werden die folgenden Annahmen getroffen:

- Der Schaltzustand (die Topologie) des Netzes ist bekannt.
- Der Erdschlußwiderstand am Fehlerort F ist klein gegenüber der natürlichen Unsymmetrie des Netzes.

Das mathematische Modell des Nullsystems eines einzelnen Leitungsabschnittes $L_i'$ sind die nachfolgenden Leitungsgleichungen:

$$\frac{\partial}{\partial x}u(x,t) = -r \cdot i(x,t) - l \cdot \frac{\partial}{\partial t}i(x,t)$$

$$\frac{\partial}{\partial x}i(x,t) = -g \cdot u(x,t) - c \cdot \frac{\partial}{\partial t}u(x,t)$$

mit Widerstandsbelag r, Leitwertsbelag g, Induktivitätsbelag l und Kapazitätsbelag c. Die Ausdrücke u(x,t) bzw. i(x,t) sind die Spannung bzw. der Strom an der Stelle x zum Zeitpunkt t.

Mittels Laplace-Transformation ergibt sich die Kettenmatrix A zu

$$\begin{bmatrix} \hat{u}(0,s) \\ \hat{\imath}(0,s) \end{bmatrix} = \underbrace{\begin{bmatrix} \cosh(\gamma(s)x) & Z_w(s)\sinh(\gamma(s)x) \\ Z_w^{-1}(s)\sinh(\gamma(s)x) & \cosh(\gamma(s)x) \end{bmatrix}}_{A} \cdot \begin{bmatrix} \hat{u}(x,s) \\ \hat{\imath}(x,s) \end{bmatrix}$$

mit Wellenwiderstand $Z_w$, Wellendämpfungsmaß $\gamma$:

$$Z_w(s) = \sqrt{\frac{r+sl}{g+sc}} \ , \ \gamma(s) = \sqrt{(r+sl)(g+sc)}$$

und û (x, s) bzw. î (x, s) als Laplace-Transformierte von u(x,t) bzw. i(x,t).

Damit berechnen sich die Spannung û(L,s) und der Strom î(L,s) am Ende eines Leitungsabschnittes der Länge L als Funktion der Spannung û(0,s) und des Stromes î(0,s) am Beginn dieses Leitungsabschnittes in der Form

$$\begin{bmatrix} \hat{u}(L,s) \\ \hat{\imath}(L,s) \end{bmatrix} = \underbrace{\begin{bmatrix} \cosh(\gamma(s)L) & -Z_w(s)\sinh(\gamma(s)L) \\ -Z_w^{-1}(s)\sinh(\gamma(s)L) & \cosh(\gamma(s)L) \end{bmatrix}}_{A^{-1}} \cdot \begin{bmatrix} \hat{u}(0,s) \\ \hat{\imath}(0,s) \end{bmatrix}$$

Für das Netz von Fig. 1 ergibt sich damit die Kettenmatrixdarstellung Fig. 2. Für einen Leitungsabschnitt, der am Ende offen ist, gilt î(L,s) = 0.

Die mit Stichen und Maschen versehene Kettenmatrixdarstellung von Fig. 2 wird in ein äquivalentes Ersatzschaltbild aus einer Serienschaltung von Ersatzschaltbild-Leitungsabschnitten $L_i$ übergeführt. Dazu wird zunächst die kürzeste Verbindung G von der Meßstelle A zur Meßstelle B bestimmt, beispielsweise mittels Methoden der Graphentheorie. Aus Fig. 1 folgt G = {$L_1'$, $L_2'$, $L_3'$, $L_4'$ oder $L_{12}'$, $L_5'$}.

Bezogen auf die Verbindung G werden für alle von den Leitungsabschnitten $L_i'$ gebildeten abgehenden Stiche bzw. Maschen äquivalente Kettenmatrizen $A_i$ mit Hilfe der folgenden elementaren Operationen berechnet.

Reduktion einer Reihenschaltung:

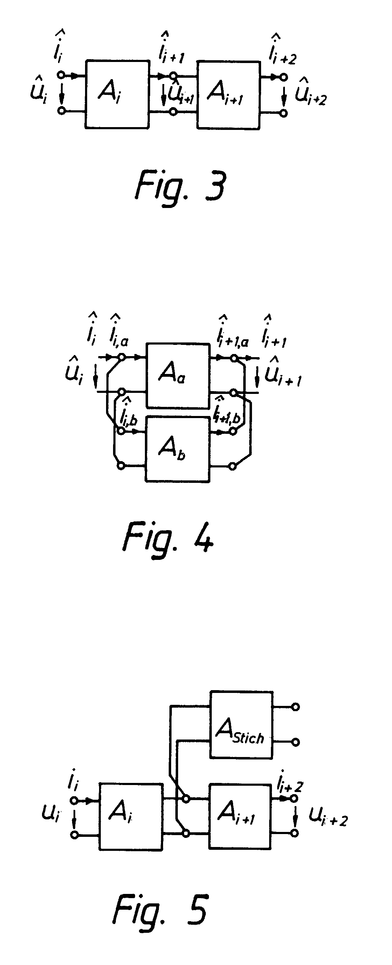

Die Reihenschaltung zweier Leitungsabschnitte mit den Kettenmatrizen $A_i$ und $A_{i+1}$ (Fig. 3) hat die äquivalente Kettenmatrix $A_{ges}$

$$A_{ges} = A_i \, A_{i+1}$$

(Diese Reduktion ist nur in einem Stich bzw. einer Masche erforderlich, nicht in der Verbindung G).

Reduktion einer Parallelschaltung (Masche) :

Die Parallelschaltung zweier Kettenmatrizen $A_a$ und $A_b$ (siehe Fig. 4) hat die äquivalente Kettenmatrix $A_{ges}$

$$A_{ges} = \begin{bmatrix} \dfrac{A_{11,b}A_{12,a} + A_{12,b}A_{11,a}}{A_{12,a} + A_{12,b}} & \dfrac{A_{12,a}A_{12,b}}{A_{12,a} + A_{12,b}} \\ \dfrac{A_{21,ges}}{A_{12,a} + A_{12,b}} & \dfrac{A_{22,b}A_{12,a} + A_{12,b}A_{22,a}}{A_{12,a} + A_{12,b}} \end{bmatrix}$$

mit

$$A_{21,ges} = -(A_{22,b}A_{11,b} - A_{22,a}A_{11,b} - A_{21,b}A_{12,a} - A_{21,b}A_{12,b} - A_{22,b}A_{11,a} - A_{21,a}A_{12,a} - A_{21,a}A_{12,b} + A_{22,a}A_{11,a})$$

Reduktion eines Stiches:

Die äquivalente Kettenmatrix für die Anschaltung eines an seinem Ende offenen Stich-Leitungsabschnittes mit der Kettenmatrix $A_{Stich}$ an den Eingang eines Leitungsabschnittes mit der Kettenmatrix $A_{i+1}$ (siehe Fig. 5) hat die folgende Form:

$$A_{ges} = A_c A_{i+1}$$

mit

$$A_c = \begin{bmatrix} 1 & 0 \\ 1/Z_{Stich} & 1 \end{bmatrix}$$

und

$$Z_{Stich} = \frac{A_{11,Stich}}{A_{21,Stich}}$$

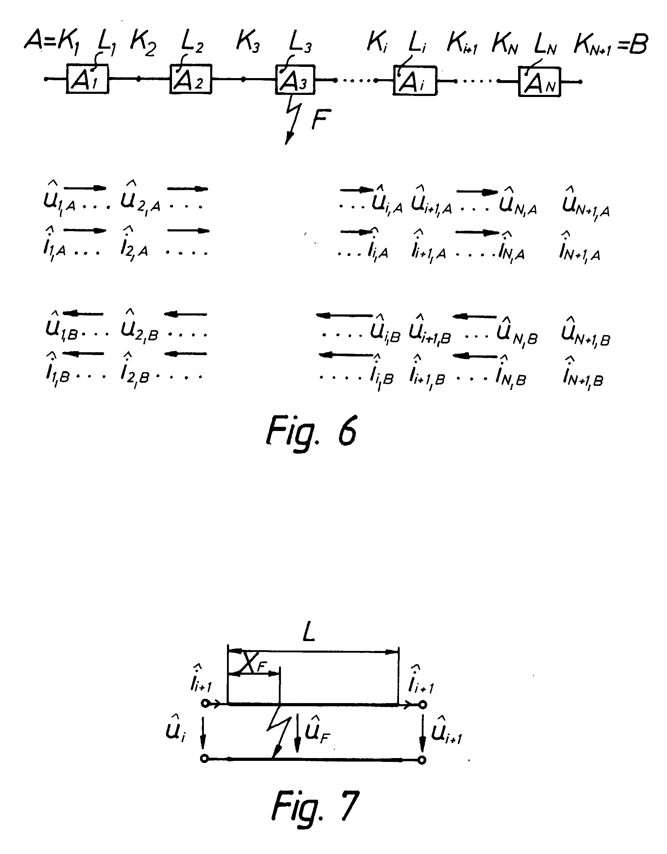

Unter Anwendung dieser Elementaroperationen, falls erforderlich rekursiv, ergibt sich die Serienschaltungs-Kettenmatrixdarstellung Fig. 6 mit den äquivalenten Serienschaltungs-Kettenmatrizen $A_i$ (i = 1..N).

Für jeden Knoten $K_i$ zwischen zwei Leitungsabschnitten in der Kettenmatrixabfolge von Fig. 6 werden die Nullspannung und der Nullstrom berechnet, u.zw. sowohl ausgehend von den Meßwerten der Nullspannung und des Nullstromes $\hat{u}_{1,A}$ und $\hat{i}_{1,A}$ an der Meßstelle A an Hand der Formel

$$\begin{bmatrix} \hat{u}_{i,A} \\ \hat{\imath}_{i,A} \end{bmatrix} = A_{i-1}^{-1} \ldots \ldots A_2^{-1} A_1^{-1} \begin{bmatrix} \hat{u}_{1,A} \\ \hat{\imath}_{1,A} \end{bmatrix} \qquad i = 2..N+1$$

als auch ausgehend von den Meßwerten der Nullspannung und des Nullstromes $\hat{u}_{N+1,B}$ und $\hat{\imath}_{N+1,B}$ an der Meßstelle B an Hand der Formel

$$\begin{bmatrix} \hat{u}_{i,B} \\ \hat{\imath}_{i,B} \end{bmatrix} = A_i \ldots \ldots A_{N-1} A_N \begin{bmatrix} \hat{u}_{N+1,B} \\ \hat{\imath}_{N+1,B} \end{bmatrix} \qquad i = 1..N$$

Mit anderen Worten werden die Nullspannungen und Nullströme der Knoten $K_i$ einmal "von links nach rechts" und ein zweites Mal "von rechts nach links" berechnet.

Es wurde gefunden, daß in beiden Rechenreihen die errechneten Werte jeweils bis zum Fehlerort F mit der Realität übereinstimmen, jedoch anschließend auf Grund des unbekannten, über die Fehlerstelle abfließenden Stromes zunehmend von der Realität abweichen.

Werden ausschließlich die Nullspannungen betrachtet, haben die Differenzen der von links nach rechts bzw. von rechts nach links berechneten Nullspannungen im Bereich des Fehlerortes ein Minimum. Es wird daher eine Folge von Differenzspannungen

$$\Delta\hat{u}_i = \hat{u}_{i,A} - \hat{u}_{i,B} \qquad i = 1..N+1$$

gebildet. Anschließend wird der Minimalwert $\Delta\hat{u}_{min}$ der Folge ermittelt; der Index min ist damit der Index f des fehlerbehafteten oder neben einem fehlerbehafteten Leitungsabschnitt liegenden Knotens $K_f$.

Wenn der Fehlerort in einem Leitungsabschnitt zwischen zwei Knoten liegt, läßt die Bestimmung des Knotens $K_f$ zunächst nur einen Rückschluß darüber zu, daß der fehlerbehaftete Leitungsabschnitt links oder rechts von diesem Knoten liegt. Für jeden der angrenzenden Leitungsabschnitte $L_{f-1}$ und $L_f$ können unter Zuhilfenahme des Ansatzes Fig. 7 die Leitungsgleichungen in Hinblick auf den Fehlerort $x_f$ gelöst werden. Jener Leitungsabschnitt, für den sich eine reelle Lösung für $x_f$ ergibt, ist der fehlerbehaftete Leitungsabschnitt.

Für den in Fig. 4 dargestellten Leitungsabschnitt ergibt die Lösung der Leitungsgleichungen

$$\begin{bmatrix} \hat{u}_f \\ \hat{\imath}_{f,1} \end{bmatrix} = \begin{bmatrix} \cosh(\gamma x_f) & -Z_w(s)\sinh(\gamma x_f) \\ -Z_w^{-1}(s)\sinh(\gamma x_f) & \cosh(\gamma x_f) \end{bmatrix} \cdot \begin{bmatrix} \hat{u}_i \\ \hat{\imath}_i \end{bmatrix}$$

und

$$\begin{bmatrix} \hat{u}_f \\ \hat{\imath}_{f,2} \end{bmatrix} = \begin{bmatrix} \cosh(\gamma(L-x_f)) & Z_w(s)\sinh(\gamma(L-x_f)) \\ Z_w^{-1}(s)\sinh(\gamma(L-x_f)) & \cosh(\gamma(L-x_f)) \end{bmatrix} \cdot \begin{bmatrix} \hat{u}_{i+1} \\ \hat{\imath}_{i+1} \end{bmatrix}$$

wobei $\hat{\imath}_{f,1}$ und $\hat{\imath}_{f,2}$ der am Erdschlußort vom einen bzw. anderen Leitungsende her fließende Strom ist, die analytische Formel

$$x_f = L - \frac{1}{\gamma}\ln\left(\pm\frac{\sqrt{-k_1 e^{\gamma L}\left((u_i - Z_w i_i)e^{\gamma L} - (u_{i+1} - Z_w i_{i+1})\right)}}{k_1}\right)$$

mit

$$k_1 = (u_i + Z_W i_i) - (u_{i+1} + Z_W i_{i+1}) e^{\gamma L}$$

Anstelle einer exakten Lösung der Leitungsgleichungen kann auch eine näherungsweise Lösung, z.B. mit Hilfe linearer Interpolation, aufgesucht werden.

Je genauer die Kettenmatrizen der Leitungsabschnitte bekannt sind, desto genauer lassen sich der fehlerbehaftete Knoten $K_f$, fehlerbehaftete Leitungsabschnitt bzw. der Fehlerort $x_f$ bestimmen.

Die Genauigkeit der Bestimmung hängt aber auch von allfälligen Meßfehlern bei der Messung der Nullspannungen und Nullströme in den Meßstellen ab. Insbesondere die zur Messung der Nullströme verwendeten Stromwandler unterliegen in der Praxis signifikanten Meßfehlern. Die im folgenden dargestellte Variante des erfindungsgemäßen Verfahrens berücksichtigt sowohl derartige Stromwandlermeßfehler als auch Ungenauigkeiten in den Annahmen der Leitungsparameter.

Für dieses Verfahren ist es erforderlich, daß das Nullsystem des Drehstromnetzes beeinflußt werden kann, um verschiedene Arbeitspunkte des Netzes einstellen zu können. Unter einer "Beeinflussung des Nullsystems" werden insbesondere eine oder mehrere beliebige der folgenden Maßnahmen verstanden:

- Einspeisen eines Hilfssignales in den Sternpunkt des Drehstromnetzes,
- Verstimmen der Petersen-Spule (falls vorhanden),
- Zuschalten einer Hilfsimpedanz zwischen Sternpunkt und Erde

Das Verfahren ist nicht auf diese Aufzählung beschränkt, sondern es sind alle dem Fachmann bekannten Maßnahmen einsetzbar, mit denen eine Änderung des Arbeitspunktes des Nullsystems eines Drehstromnetzes möglich ist, z.B. Verändern der Netzfrequenz, Netzspannung, od.dgl.

Zur Berücksichtigung der Stromwandlermeßfehler werden die folgenden Fehleransätze für die (Meß-) Istwerte $\hat{i}_{1,A,ist}$ und $\hat{i}_{N+1,B,ist}$ der in den Meßstellen A und B herrschenden (wahren) Nullströme $\hat{i}_{1,A}$ und $\hat{i}_{N+1,B}$ getroffen:

$$\hat{i}_{1,A,ist} = (1 + r_A)\hat{i}_{1,A}$$

$$\hat{i}_{N+1,B,ist} = (1 + r_B)\hat{i}_{N+1,B}$$

mit

$r_A$ ... relativer Meßfehler (komplex) in der Meßstelle A
$r_B$ ... relativer Meßfehler (komplex) in der Meßstelle B

Wie oben erwähnt, gilt an der Fehlerstelle i = f im Idealfall (keine Stromwandlermeßfehler, exakte Leitungsparameter)

$$\Delta \hat{u}_f = \hat{u}_{f,A} - \hat{u}_{f,B} = 0$$

Für den Realfall (Stromwandlermeßfehler, ungenaue Leitungsparameter) läßt sich

$$\Delta \hat{u}_{f,ist} = \hat{u}_{f,A,ist} - \hat{u}_{f,B,ist}$$

mit Hilfe der Kettenmatrixgleichungen

$$\begin{bmatrix} \hat{u}_{f,A,ist} \\ \hat{i}_{f,A,ist} \end{bmatrix} = \underbrace{A_{f-1}^{-1} \cdots A_2^{-1} A_1^{-1}}_{X_f} \begin{bmatrix} \hat{u}_{1,A} \\ \hat{i}_{1,A,ist} \end{bmatrix} \quad \text{und} \quad \begin{bmatrix} \hat{u}_{f,B,ist} \\ \hat{i}_{f,B,ist} \end{bmatrix} = \underbrace{A_f \cdots A_{N-1} A_N}_{\bar{X}_f} \begin{bmatrix} \hat{u}_{N+1,B} \\ \hat{i}_{N+1,B,ist} \end{bmatrix} \; ,$$

der Vereinfachung

$$X_f = \begin{bmatrix} X_{11,f} & X_{12,f} \\ X_{21,f} & X_{22,f} \end{bmatrix} \quad \text{und} \quad \overline{X}_f = \begin{bmatrix} \overline{X}_{11,f} & \overline{X}_{12,f} \\ \overline{X}_{21,f} & \overline{X}_{22,f} \end{bmatrix}$$

und den obigen Meßfehleransätzen schreiben als:

$$\Delta u_{f,ist} = X_{12,f} \frac{r_A}{(1+r_A)} \hat{i}_{1,A,ist} - \overline{X}_{12,f} \frac{r_B}{(1+r_B)} \hat{i}_{N+1,B,ist}$$

Nimmt man nun zunächst an, daß nur ein Stromwandler fehlerbehaftet ist, d.h. $r_A = 0$ oder $r_B = 0$, dann folgt z.B. für $r_A = 0$

$$\Delta \hat{u}_{f,ist} = - \overline{X}_{12,f} \frac{r_B}{(1+r_B)} \hat{i}_{N+1,B,ist}$$

Bei zwei verschiedenen Arbeitspunkten des Netzes, die mit den Indizes I und II bezeichnet werden, lassen sich somit die beiden Gleichungen aufstellen:

$$\Delta \hat{u}_{f,ist,I} = - \overline{X}_{12,f} \frac{r_B}{(1+r_B)} \hat{i}_{N+1,B,ist,I} \qquad \Delta \hat{u}_{f,ist,II} = - \overline{X}_{12,f} \frac{r_B}{(1+r_B)} \hat{i}_{N+1,B,ist,II}$$

(bzw. für $r_B = 0$:

$$\Delta \hat{u}_{f,ist,I} = - X_{12,f} \frac{r_A}{(1+r_A)} \hat{i}_{1,A,ist,I} \qquad \Delta \hat{u}_{f,ist,II} = - X_{12,f} \frac{r_A}{(1+r_A)} \hat{i}_{1,A,ist,II})$$

Daraus ergibt sich, daß für die Fehlerstelle f die Bedingungen

$$\frac{\Delta \hat{u}_{f,ist,I}}{\hat{i}_{N+1,B,ist,I}} - \frac{\Delta \hat{u}_{f,ist,II}}{\hat{i}_{N+1,B,ist,II}} = 0 \text{ und } \frac{\Delta \hat{u}_{f,ist,I}}{\hat{i}_{1,A,ist,I}} - \frac{\Delta \hat{u}_{f,ist,II}}{\hat{i}_{1,A,ist,II}} = 0$$

gelten müssen.

Demnach kann die Fehlerstelle i = f aufgefunden werden, indem die Nullstelle bzw. das Minimum des Ausdruckes

$$\Delta \hat{a}_{i,A} = \frac{\Delta \hat{u}_{i,ist,I}}{\hat{i}_{1,A,ist,I}} - \frac{\Delta \hat{u}_{i,ist,II}}{\hat{i}_{1,A,ist,II}} \qquad \text{mit i = 1..N+1}$$

bzw.

$$\Delta \hat{a}_{i,B} = \frac{\Delta \hat{u}_{i,ist,I}}{\hat{i}_{N+1,B,ist,I}} - \frac{\Delta \hat{u}_{i,ist,II}}{\hat{i}_{N+1,B,ist,II}} \qquad \text{mit i = 1..N+1}$$

aufgefunden wird. In der Praxis ergibt sich kein exakter Nullwert, sondern nur ein Minimum.

Die verfahrenstechnische Implementierung der Minimalwertsuche von $\Delta \hat{a}_{i,A}$ bzw. $\Delta \hat{a}_{i,B}$ kann in der folgenden Weise durchgeführt werden (Zur Vereinfahcung wird hier auf den Index "ist" verzichtet; die Meßwerte beziehen sich jedoch weiterhin auf die Ist-Meßwerte).

Es wird von einem ersten Arbeitspunkt I des Netzes ausgegangen. Beim Arbeitspunkt I wird zunächst eine

erste Differenzspannungsfolge

$$\Delta \hat{u}_{i,I} = \hat{u}_{i,A,I} - \hat{u}_{i,B,I} \qquad i=1..N+1$$

wie oben beschrieben bestimmt.

Die erste Folge von Differenzspannungen $\Delta\hat{u}_{i,I}$ wird auf den Nullstrom an einem der Meßpunkte A oder B normiert (z.B. A), um eine erste Quotientenfolge

$$\hat{a}_{i,I} = \Delta\hat{u}_{i,I} / \hat{\imath}_{1,A,I} \qquad i = 1..N+1$$

zu erzeugen.

(Alternativ könnte die Normierung auch auf den Nullstrom im Meßpunkt B erfolgen, z.B.

$$\hat{a}_{i,I} = \Delta\hat{u}_{i,I} / \hat{\imath}_{N+1,B,I} \qquad i = 1..N+1)$$

Nun wird das Nullsystem des Drehstromnetzes wie beschrieben verändert, um den zweiten Arbeitspunkt II einzustellen.

Beim zweiten Arbeitspunkt II werden eine zweite Folge von Differenzspannungen

$$\Delta\hat{u}_{i,II} = \hat{u}_{i,A,II} - \hat{u}_{i,B,II} \qquad i = 1..N+1,$$

eine zweite Folge von Quotienten

$$\hat{a}_{i,II} = \Delta\hat{u}_{i,II} / \hat{\imath}_{1,A,II} \qquad i = 1..N+1$$

ermittelt.

Aus der ersten und der zweiten Quotientenfolge wird eine Differenz-Quotientenfolge $\Delta\hat{a}_i$

$$\Delta\hat{a}_i = \hat{a}_{i,II} - \hat{a}_{i,I} \qquad i= 1..N+1$$

gebildet.

Nun kann der Minimalwert $\Delta\hat{a}_{min}$ der Differenzfolge bestimmt werden. Der Index min stellt den Index f des fehlerbehafteten Knotens $K_f$ dar bzw. desjenigen Knotens, der neben dem fehlerbehafteten Leitungsabschnitt liegt.

Wenn der Fehler im Knoten liegt, ist $\Delta\hat{a}_{min} \cong 0$. Andernfalls werden die Nachbarwerte $\Delta\hat{a}_{min+1}$ und $\Delta\hat{a}_{min-1}$ ermittelt, und der fehlerbehaftete Leitungsabschnittes $L_f$ ist jener Leitungsabschnitt, der zwischen jenen beiden Knoten liegt, zwischen denen die Phase von $\Delta\hat{a}$ um etwa $\pi$ wechselt.

Wieder kann der exakte Fehlerort im Leitungsabschnitt mit Hilfe von analytischen Lösungen wie oben beschrieben ermittelt werden.

Die Normierung der Differenzspannungsfolgen kann sowohl auf den Nullstrom an der Meßstelle A als auch auf den Nullstrom an der Meßstelle B erfolgen. Für beide Arbeitspunkte I und II ist jedoch dieselbe Normierung zu wählen.

Mit Kenntnis des Fehlerortes f lassen sich nun die relativen Stromwandlermeßfehler $r_A$ bzw. $r_B$ rückrechnen:

$$r_B = -\frac{\Delta\hat{u}_{f,ist,I}}{\Delta\hat{u}_{f,ist,I} + \overline{X}_{12,f}\hat{\imath}_{N+1,B,ist,I}} \quad \text{bzw.} \quad r_A = -\frac{\Delta\hat{u}_{f,ist,I}}{\Delta\hat{u}_{f,ist,I} + X_{12,f}\hat{\imath}_{1,A,ist,I}}$$

Die vorgenannten Überlegungen lassen sich auf den Fall erweitern, daß beide Stromwandler fehlerbehaftet sind, so daß ailt:

$$\frac{\Delta \hat{u}_{f,ist,I}}{\hat{i}_{N+1,B,ist,I}} - \frac{\Delta \hat{u}_{f,ist,II}}{\hat{i}_{N+1,B,ist,II}} - X_{12,f}\frac{r_A}{(1+r_A)}\underbrace{\left(\frac{\hat{i}_{1,A,ist,I}}{\hat{i}_{N+1,B,ist,I}} - \frac{\hat{i}_{1,A,ist,II}}{\hat{i}_{N+1,B,ist,II}}\right)}_{\Lambda_1} = 0$$

$$\frac{\Delta \hat{u}_{f,ist,I}}{\hat{i}_{1,A,ist,I}} - \frac{\Delta \hat{u}_{f,ist,II}}{\hat{i}_{1,A,ist,II}} + \overline{X}_{12,f}\frac{r_B}{(1+r_B)}\underbrace{\left(\frac{\hat{i}_{N+1,B,ist,I}}{\hat{i}_{1,A,ist,I}} - \frac{\hat{i}_{N+1,B,ist,II}}{\hat{i}_{1,A,ist,II}}\right)}_{\Lambda_2} = 0$$

Bei Verwendung praktischer relevanter Daten stellt sich heraus, daß die Ausdrücke $\Lambda_1$ und $\Lambda_2$ vernachlässigbar klein sind. Die beiden Gleichungen reduzieren sich daher wieder auf die oben genannten Beziehungen, so daß der Fehlerort in der selben Weise wie im Falle nur eines fehlerbehafteten Stromwandlers gefungen werden kann.

Mit Kenntnis des Fehlerortes f lassen sich auch in diesem Fall die relativen Stromwandlermeßfehler berechnen:

$$\frac{r_A}{(1+r_A)}=\frac{\Delta\hat{u}_{f,ist,I}\hat{i}_{N+1,B,ist,II}-\Delta\hat{u}_{f,ist,II}\hat{i}_{N+1,B,ist,I}}{(\hat{i}_{1,A,ist,I}\hat{i}_{N+1,B,ist,II}-\hat{i}_{1,A,ist,II}\hat{i}_{N+1,B,ist,I})X_{12,f}}$$

$$\frac{r_B}{(1+r_B)}=\frac{\Delta\hat{u}_{f,ist,I}\hat{i}_{1,A,ist,II}-\Delta\hat{u}_{f,ist,II}\hat{i}_{1,A,ist,I}}{(\hat{i}_{1,A,ist,I}\hat{i}_{N+1,B,ist,II}-\hat{i}_{1,A,ist,II}\hat{i}_{N+1,B,ist,I})\overline{X}_{12,f}}$$

Genauere Untersuchungen in der Praxis haben gezeigt, daß die vorgestellte Minimalwertsuche von $\Delta\hat{a}_{min}$ selbst dann zu einem Erfolg führt, wenn die Leitungsparameter, z.B. die Kettenmatrizen, nicht exakt angegeben werden können. Selbst bei einer Kombination aus Stromwandlermeßfehlern und ungenauen Leitungsparametern arbeitet das vorgestellte Verfahren noch zufriedenstellend.

Durch Definition von Toleranzbereichen in den Leitungsparametern bzw. Kettenmatrizen der Leitungsabschnitte und der Netzstruktur kann ein Vertrauensbereich für den ermittelten Wert $x_f$ des Fehlerortes angegeben werden. Dabei bestehen die Möglichkeiten

- Toleranzen für die Leitungsparameter der einzelnen Abschnitte anzugeben,
- bei ungenauen topologischen Kenntnissen Vereinfachungen hinsichtlich der Topologie zu treffen, z.B. die Annahme, daß keine Stiche vorhanden sind, oder es wird nur eine rudimentäre Modellierung der Stiche durchgeführt,
- bei Unkenntnis der zugrundeliegenden Netzparameter entsprechende Annahmen von Durchschnittswerten für Kabel und Freileitungen zu treffen.

Die Berechnung des Vertrauensbereiches für $x_f$ erfolgt beispielsweise derart, daß für die angenommenen Parameter, z.B. die Leitungsparameter, die Randwerte ihres Toleranzbereiches ("worst case"-Werte) eingesetzt werden, um die Randwerte des Toleranzbereiches von $x_f$ zu bestimmen.

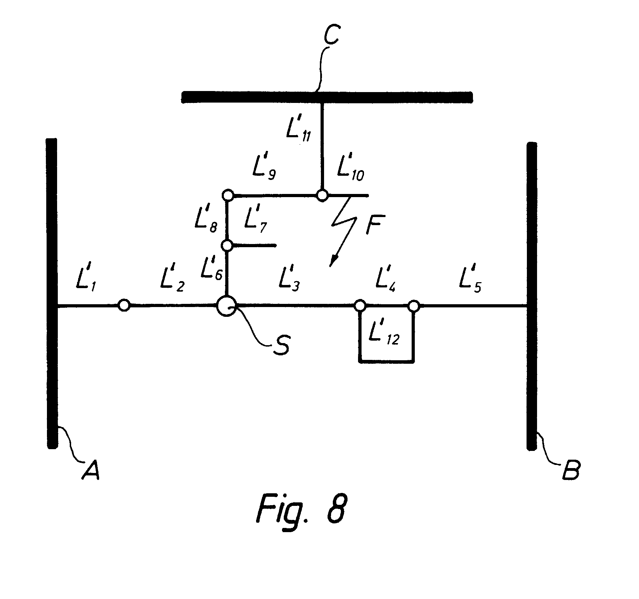

Die vorgestellten Verfahren sind ohne zusätzlichen Aufwand auch auf Netze mit mehr als zwei Meßstellen übertragbar. Fig. 8 zeigt ein derartiges Netz mit drei Stationen A, B und C. Liegt der Erdschluß auf dem Abschnitt zwischen dem gemeinsamen Punkt S und der Meßstelle C, so liefern die von den Meßstellen A und B ausgehend berechneten Nullspannungen an dem Punkt S den gleichen Wert, bzw. die Differenzspannung $\Delta\hat{u}_i= 0$. Dies zeigt an, daß sich der Fehler auf der Strecke von S zu C befindet. Es können nun die erfindungsgemäßen Verfahren entweder auf die Strecke von A nach C oder auf die Strecke von B nach C angewandt werden. Auch beide Auswertungen können vorgenommen und die zusätzlich erhaltenen Daten zur Korrektur von Parameterunsicherheiten ausgenützt werden.

Die Erfindung ist selbstverständlich nicht auf die dargestellten Ausführungsbeispiele beschränkt, sondern umfaßt alle Varianten, die in den Rahmen der angeschlossenen Ansprüche fallen. Beispielsweise können anstelle der genannten Laplacetransformationen Fouriertransformationen oder beliebige andere in der Technik bekannten Transformationen verwendet werden, welche für Matrixoperationen geeignet sind.

Anstelle der beschriebenen Verwendung von Kettenmatrizen zur Beschreibung der Leitungsabschnitte können sämtliche in der Mehrtortheorie bekannten Leitungsbeschreibungsmodelle verwendet werden, z.B. Impedanzmatrizen Z, Admittanzmatrizen Y, Hybridmatrizen H, inverse Hybridmatrizen P, Streumatrizen S, inverse Streumatrizen T usw. Wie dem Fachmann bekannt, können diese Beschreibungsmodelle in äquivalenter Weise ineinander bzw. in die Kettenmatrixdarstellung übergeführt werden; bei Verwendung anderer Matrixdarstellungen als der Kettenmatrixdarstellung sind die in der vorliegenden Beschreibung angeführten Ableitungen entsprechend überzuführen.

Selbstverständlich können die genannten Verfahrensschritte auch in äquivalenter Weise ausgeführt und verwirklicht werden; so können beispielsweise zuerst die Nullströme und Nullspannungen in den beiden Arbeitspunkten I und II des Netzes ermittelt werden, und erst anschließend die entsprechenden Folgen und Differenzen gebildet werden. Ebenso ist es äquivalent, Folgen von Differenzen oder Differenzen von Folgen zu bilden. Die einzelnen Verfahrensschritte können daher in äquivalenter Weise umgruppiert werden, wie für den Fachmann offensichtlich ist.

**Patentansprüche**

1. Verfahren zum Bestimmen desjenigen Knotens $K_f$ aus einer Abfolge von Knoten $K_2..K_N$, die zwischen aufeinanderfolgenden, in einem Drehstromnetz zwischen zwei Meßstellen $A=K_1$, $B=K_{N+1}$ liegenden und die Nullsystem-Mehrtorbeschreibungsmatrizen $A_1..A_N$ aufweisenden Leitungsabschnitten $L_1..L_N$ liegen, welcher mit einem Erdschluß behaftet ist oder neben einem erdschlußbehafteten Leitungsabschnitt liegt, gekennzeichnet durch die Schritte:

   - Messen der Nullspannung $\hat{u}_{1,A}$ und des Nullstromes $\hat{\imath}_{1,A}$ an der Meßstelle A sowie der Nullspannung $\hat{u}_{N+1,B}$ und des Nullstromes $\hat{\imath}_{N+1,B}$ an der Meßstelle B im Laplacebereich, Fourierbereich od.dgl.;
   - Berechnen einer ersten Folge von Nullspannungen $\hat{u}_{i,A}$ und Nullströmen $\hat{\imath}_{i,A}$ an jedem Knoten $K_i$ von der Meßstelle A aus gesehen, anhand der Meßwerte $\hat{u}_{1,A}$ und $\hat{\imath}_{1,A}$ und der Mehrtorbeschreibungsmatrizen $A_1...A_N$;
   - Berechnen einer zweiten Folge von Nullspannungen $\hat{u}_{i,B}$ und Nullströmen $\hat{\imath}_{i,B}$ an jedem Knoten $K_i$ von der Meßstelle B aus gesehen, anhand der Meßwerte $\hat{u}_{N+1,B}$ und $\hat{\imath}_{N+1,B}$ und der Mehrtorbeschreibungsmatrizen $A_1...A_N$;
   - Berechnen einer Differenzspannungsfolge $\Delta\hat{u}_i$ aus erster und zweiter Nullspannungsfolge; und
   - Aufsuchen des Minimalwertes $\Delta\hat{u}_{min}$ der Differenzspannungsfolge und Anzeigen des Index min als Index f des fehlerbehafteten oder neben einem fehlerbehafteten Leitungsabschnitt liegenden Knotens $K_f$.

2. Verfahren nach Anspruch 1, dadurch gekennzeichnet, daß die Mehrtorbeschreibungsmatrizen die Kettenmatrizen der Leitungsabschnitte sind und daß

   - das Berechnen der ersten Folge von Nullspannungen $\hat{u}_{i,A}$ und Nullströmen $\hat{\imath}_{i,A}$ anhand der Formel:

$$\begin{bmatrix} \hat{u}_{i,A} \\ \hat{\imath}_{i,A} \end{bmatrix} = A_{i-1}^{-1}.....A_2^{-1}A_1^{-1}\begin{bmatrix} \hat{u}_{1,A} \\ \hat{\imath}_{1,A} \end{bmatrix} \qquad \text{i = 2..N+1;}$$

   und
   - das Berechnen der zweiten Folge von Nullspannungen $\hat{u}_{i,B}$ und Nullströmen $\hat{\imath}_{i,B}$ anhand der Formel:

$$\begin{bmatrix} \hat{u}_{i,B} \\ \hat{\imath}_{i,B} \end{bmatrix} = A_i.....A_{N-1}A_N\begin{bmatrix} \hat{u}_{N+1,B} \\ \hat{\imath}_{N+1,B} \end{bmatrix} \qquad \text{i = 1..N}$$

   erfolgt.

3. Verfahren zum Bestimmen desjenigen Knotens $K_f$ aus einer Abfolge von Knoten $K_2..K_N$, die zwischen aufeinanderfolgenden, in einem Drehstromnetz zwischen zwei Meßstellen $A=K_1$, $B=K_{N+1}$ liegenden und die Nullsystem-Mehrtorbeschreibungsmatrizen $A_1..A_N$ aufweisenden Leitungsabschnitten $L_1..L_N$ liegen, welcher mit einem Erdschluß behaftet ist oder neben einem erdschlußbehafteten Leitungsabschnitt liegt, gekennzeichnet durch die Schritte:

   a) Bei einem ersten Arbeitspunkt I des Netzes:

- Messen der Nullspannung $\hat{u}_{1,A,I}$ und des Nullstromes $\hat{\imath}_{1,A,I}$ an der Meßstelle A sowie der Nullspannung $\hat{u}_{N+1,B,I}$ und des Nullstromes $\hat{\imath}_{N+1,B,I}$ an der Meßstelle B im Laplacebereich, Fourierbereich od.dgl.;
- Berechnen einer ersten Folge von Nullspannungen $\hat{u}_{i,A,I}$ und Nullströmen $\hat{\imath}_{i,A,I}$ an jedem Knoten $K_i$ von der Meßstelle A aus gesehen, anhand der Meßwerte $\hat{u}_{1,A,I}$ und $\hat{\imath}_{1,A,I}$ und der Mehrtorbeschreibungsmatrizen $A_1...A_N$;
- Berechnen einer zweiten Folge von Nullspannungen $\hat{u}_{i,B,I}$ und Nullströmen $\hat{\imath}_{i,B,I}$ an jedem Knoten $K_i$ von der Meßstelle B aus gesehen, anhand der Meßwerte $\hat{u}_{N+1,B,I}$ und $\hat{\imath}_{N+1,B,I}$ und der Mehrtorbeschreibungsmatrizen $A_1...A_N$;
- Berechnen einer ersten Differenzspannungsfolge $\Delta\hat{u}_{i,I}$ aus erster und zweiter Nullspannungsfolge;
- Normieren der ersten Differenzspannungsfolge $\Delta\hat{u}_{i,I}$ auf den Nullstrom an einem der Meßpunkte A oder B zur Erzeugung einer ersten Quotientenfolge $\hat{a}_{i,I}$;

b) Beeinflussen des Nullsystems des Drehstromnetzes durch eine oder mehrere der Maßnahmen: Einspeisen eines Hilfssignales in den Sternpunkt, Verstimmen der Petersen-Spule (falls vorhanden), Zuschalten einer Hilfsimpedanz zwischen Sternpunkt und Erde, od.dgl., zur Einstellung eines zweiten Arbeitspunktes II des Netzes;

c) Beim zweiten Arbeitspunkt II des Netzes:

- Messen der Nullspannung $\hat{u}_{1,A,II}$ und des Nullstromes $\hat{\imath}_{1,A,II}$ an der Meßstelle A sowie der Nullspannung $\hat{u}_{N+1,B,II}$ und des Nullstromes $\hat{\imath}_{N+1,B,II}$ an der Meßstelle B im Laplacebereich, Fourierbereich od.dgl.;
- Berechnen einer dritten Folge von Nullspannungen $\hat{u}_{i,A,II}$ und Nullströmen $\hat{\imath}_{i,A,II}$ an jedem Knoten $K_i$ von der Meßstelle A aus gesehen, anhand der Meßwerte $\hat{u}_{1,A,II}$ und $\hat{\imath}_{1,A,II}$ und der Mehrtorbeschreibungsmatrizen $A_1...A_N$;
- Berechnen einer vierten Folge von Nullspannungen $\hat{u}_{i,B,II}$ und Nullströmen $\hat{\imath}_{i,B,II}$ an jedem Knoten $K_i$ von der Meßstelle B aus gesehen, anhand der Meßwerte $\hat{u}_{N+1,B,II}$ und $\hat{\imath}_{N+1,B,II}$ und der Mehrtorbeschreibungsmatrizen $A_1...A_N$;
- Berechnen einer zweiten Differenzspannungsfolge aus dritter und vierter Nullspannungsfolge;
- Normieren der zweiten Differenzspannungsfolge auf den Nullstrom am selben der Meßpunkte A oder B wie zuvor beim Arbeitspunkt I, zur Erzeugung einer zweiten Quotientenfolge $\hat{a}_{i,II}$;

d) Berechnen einer Differenz-Quotientenfolge $\Delta\hat{a}_i$ aus erster und zweiter Quotientenfolge; und
e) Aufsuchen des Minimalwertes $\Delta\hat{a}_{min}$ der Differenz-Quotientenfolge und Anzeigen des Index min als Index f des fehlerbehafteten oder neben einem fehlerbehafteten Leitungsabschnitt liegenden Knotens $K_f$.

4. Verfahren nach Anspruch 3, dadurch gekennzeichnet, daß die Mehrtorbeschreibungsmatrizen $A_1..A_N$ die Kettenmatrizen der Leitungsabschnitte $L_1..L_N$ sind, und daß

- das Berechnen der ersten Folge von Nullspannungen $\hat{u}_{i,A,I}$ und Nullströmen $\hat{\imath}_{i,A,I}$ anhand der Formel:

$$\begin{bmatrix} \hat{u}_{i,A,I} \\ \hat{\imath}_{i,A,I} \end{bmatrix} = A_{i-1}^{-1}.....A_2^{-1}A_1^{-1}\begin{bmatrix} \hat{u}_{1,A,I} \\ \hat{\imath}_{1,A,I} \end{bmatrix} \qquad \mathtt{i\ =\ 2..N+1;}$$

- das Berechnen der zweiten Folge von Nullspannungen $\hat{u}_{i,B,I}$ und Nullströmen $\hat{\imath}_{i,B,I}$ anhand der Formel:

$$\begin{bmatrix} \hat{u}_{i,B,I} \\ \hat{\imath}_{i,B,I} \end{bmatrix} = A_i.....A_{N-1}A_N\begin{bmatrix} \hat{u}_{N+1,B,I} \\ \hat{\imath}_{N+1,B,I} \end{bmatrix} \qquad \mathtt{i\ =\ 1..N;}$$

- das Berechnen der dritten Folge von Nullspannungen $\hat{u}_{i,A,II}$ und Nullströmen $\hat{\imath}_{i,A,II}$ anhand der Formel:

$$\begin{bmatrix} \hat{u}_{i,A,II} \\ \hat{\imath}_{i,A,II} \end{bmatrix} = A_{i-1}^{-1}.....A_2^{-1}A_1^{-1}\begin{bmatrix} \hat{u}_{1,A,II} \\ \hat{\imath}_{1,A,II} \end{bmatrix} \qquad \mathtt{i\ =\ 2..N+1;}$$

und

- das Berechnen der vierten Folge von Nullspannungen $\hat{u}_{i,B,II}$ und Nullströmen $\hat{i}_{i,B,II}$ anhand der Formel:

$$\begin{bmatrix} \hat{u}_{i,B,II} \\ \hat{i}_{i,B,II} \end{bmatrix} = A_i \ldots\ldots A_{N-1} A_N \begin{bmatrix} \hat{u}_{N+1,B,II} \\ \hat{i}_{N+1,B,II} \end{bmatrix} \qquad \texttt{i = 1..N}$$

erfolgt.

5. Verfahren zum Bestimmen desjenigen Knotens $K_f$ aus einer Abfolge von Knoten $K_2..K_N$, die zwischen aufeinanderfolgenden, in einem Drehstromnetz zwischen zwei Meßstellen $A=K_1$, $B=K_{N+1}$ liegenden und die Mitsystem-Mehrtorbeschreibungsmatrizen $A_1..A_N$ aufweisenden Leitungsabschnitten $L_1..L_N$ liegen, welcher mit einem Phase/Phase-Schluß behaftet ist oder neben einem fehlerbehafteten Leitungsabschnitt liegt, gekennzeichnet durch die Schritte:

- Messen der Mitspannung $\hat{u}_{1,A}$ und des Mitstromes $\hat{i}_{1,A}$ an der Meßstelle A sowie der Mitspannung $\hat{u}_{N+1,B}$ und des Mitstromes $\hat{i}_{N+1,B}$ an der Meßstelle B im Laplacebereich, Fourierbereich od.dgl.;
- Berechnen einer ersten Folge von Mitspannungen $\hat{u}_{i,A}$ und Mitströmen $\hat{i}_{i,A}$ an jedem Knoten $K_i$ von der Meßstelle A aus gesehen, anhand der Meßwerte $\hat{u}_{1,A}$ und $\hat{i}_{1,A}$ und der Mehrtorbeschreibungsmatrizen $A_1...A_N$;
- Berechnen einer zweiten Folge von Mitspannungen $\hat{u}_{i,B}$ und Mitströmen $\hat{i}_{i,B}$ an jedem Knoten $K_i$ von der Meßstelle B aus gesehen, anhand der Meßwerte $\hat{u}_{N+1,B}$ und $\hat{i}_{N+1,B}$ und der Mehrtorbeschreibungsmatrizen $A_1...A_N$;
- Berechnen einer Differenzspannungsfolge aus erster und zweiter Mitspannungsfolge;
- Aufsuchen des Minimalwertes $\Delta\hat{u}_{min}$ der Folge und Anzeigen des Index min als Index f des fehlerbehafteten oder neben einem fehlerbehafteten Leitungsabschnitt liegenden Knotens $K_f$.

6. Verfahren nach einem der Ansprüche 1 bis 5, weiters zum Bestimmen des Fehlerortes $x_f$ innerhalb des fehlerbehafteten Leitungsabschnittes $L_f$, gekennzeichnet durch den zusätzlichen Schritt des Berechnens des Fehlerortes $x_f$ ausgehend von den Null- bzw. Mitströmen und -spannungen auf beiden Seiten des Leitungsabschnittes $L_f$, z. B. durch Interpolation, Lösen der Leitungsgleichungen, od.dgl.

7. Verfahren nach Anspruch 6, dadurch gekennzeichnet, daß der Fehlerort $x_f$ innerhalb des fehlerbehafteten Leitungsabschnittes $L_f$ anhand der Gleichung

$$x_f = L - \frac{1}{\gamma} \ln\left( \pm \frac{\sqrt{-k_1 e^{\gamma L}\left(\left(u_f - Z_W i_f\right)e^{\gamma L} - \left(u_{f+1} - Z_W i_{f+1}\right)\right)}}{k_1} \right)$$

mit

$$k_1 = (u_f + Z_W i_f) - (u_{f+1} + Z_W i_{f+1})e^{\gamma L}$$

L...Leitungslänge des Leitungsabschnittes $L_f$
$Z_W$... Wellenwiderstand des Leitungsabschnittes $L_f$
$\gamma$... Wellendämpfungsmaß des Leitungsabschnittes $L_f$

($\hat{u}_f$, $\hat{i}_f$) und ($\hat{u}_{f+1}$, $\hat{i}_{f+1}$) ...Null- oder Mitspannung bzw. -strom
auf beiden Seiten des Leitungsabschnittes $L_f$ bestimmt wird.

8. Verfahren nach einem der Ansprüche 1 bis 7 für Drehstromnetze, deren Leitungsabschnitte $L_i'$ Maschen und/oder Stichleitungen bilden, gekennzeichnet durch die vorherigen Schritte des
Bestimmens einer kürzesten Verbindung G aus Leitungsabschnitten $L_i'$ zwischen den Meßstellen A und B, und

Berechnens eines äquivalenten Ersatzschaltbildes aus einer entlang von G verlaufenden Serienschaltung von Ersatzschaltbild-Leitungsabschnitten $L_i$ mittels ein- oder mehrfacher Anwendung einer oder mehrerer der folgenden Reduktionsschritte:

- Reduzieren einer Reihenschaltung zweier Leitungsabschnitte mit den Kettenmatrizen $A_i$ und $A_{i+1}$ zu einer äquivalenten Kettenmatrix $A_{ges}$, bevorzugt anhand der Gleichung:

$$A_{ges} = A_i \, A_{i+1};$$

- Reduzieren einer Parallelschaltung (Masche) zweier Kettenmatrizen $A_a$ und $A_b$ zu einer äquivalenten Kettenmatrix $A_{ges}$, bevorzugt anhand der Gleichung:

$$A_{ges} = \begin{bmatrix} \dfrac{A_{11,b}A_{12,a} + A_{12,b}A_{11,a}}{A_{12,a} + A_{12,b}} & \dfrac{A_{12,a}A_{12,b}}{A_{12,a} + A_{12,b}} \\[2ex] \dfrac{A_{21,ges}}{A_{12,a} + A_{12,b}} & \dfrac{A_{22,b}A_{12,a} + A_{12,b}A_{22,a}}{A_{12,a} + A_{12,b}} \end{bmatrix}$$

mit

$$A_{21,ges} = -(A_{22,b}A_{11,b} - A_{22,a}A_{11,b} - A_{21,b}A_{12,a} - A_{21,b}A_{12,b} -$$

$$A_{22,b}A_{11,a} - A_{21,a}A_{12,a} - A_{21,a}A_{12,b} + A_{22,a}A_{11,a}) \, ;$$

- Reduzieren einer Anschaltung (Stich) eines an seinem Ende offenen Stich-Leitungsabschnittes mit der Kettenmatrix $A_{Stich}$ an den Eingang eines Leitungsabschnittes mit der Kettenmatrix $A_{i+1}$ zu einer äquivalenten Serienschaltungskettenmatrix $A_{ges}$, bevorzugt anhand der Gleichung:

$$A_{ges} = A_c A_{i+1}$$

mit

$$A_c = \begin{bmatrix} 1 & 0 \\[1ex] 1/Z_{Stich} & 1 \end{bmatrix}$$

und

$$Z_{Stich} = \frac{A_{11,Stich}}{A_{21,Stich}} \, .$$

Fig. 1

Fig. 2

Fig. 3

Fig. 4

Fig. 5

$A=K_1 \quad L_1 \quad K_2 \quad L_2 \quad K_3 \quad L_3 \qquad K_i \quad L_i \quad K_{i+1} \quad K_N \quad L_N \quad K_{N+1}=B$

$$\hat{u}_{1,A} \cdots \hat{u}_{2,A} \cdots \qquad\qquad \cdots \hat{u}_{i,A} \; \hat{u}_{i+1,A} \cdots \hat{u}_{N,A} \qquad \hat{u}_{N+1,A}$$

$$\hat{i}_{1,A} \cdots \hat{i}_{2,A} \cdots \qquad\qquad \cdots \hat{i}_{i,A} \; \hat{i}_{i+1,A} \cdots \hat{i}_{N,A} \qquad \hat{i}_{N+1,A}$$

$$\hat{u}_{1,B} \cdots \hat{u}_{2,B} \cdots \qquad\qquad \cdots \hat{u}_{i,B} \; \hat{u}_{i+1,B} \cdots \hat{u}_{N,B} \qquad \hat{u}_{N+1,B}$$

$$\hat{i}_{1,B} \cdots \hat{i}_{2,B} \cdots \qquad\qquad \cdots \hat{i}_{i,B} \; \hat{i}_{i+1,B} \cdots \hat{i}_{N,B} \qquad \hat{i}_{N+1,B}$$

## Fig. 6

## Fig. 7

Fig. 8

**Europäisches Patentamt**

# EUROPÄISCHER RECHERCHENBERICHT

Nummer der Anmeldung

EP 99 89 0031

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | EP 0 464 662 A (ASEA BROWN BOVERI) 8. Januar 1992<br>* Spalte 3, Zeile 34 – Spalte 6, Zeile 16; Abbildungen 1,2 * | 1,3,5 | G01R31/08<br>H02H3/38 |
| A | UNGRAD ET AL.: "VERHALTEN VON DISTANZRELAIS BEI ERDSCHLUSSEN AUF DOPPELLEITUNGEN"<br>BROWN BOVERI MITTEILUNGEN., Bd. 56, Nr. 10, Oktober 1969, Seiten 494-501, XP002059449<br>BADEN CH<br>* Seite 494 – Seite 495 * | 1,3,5 | |
| A | US 4 091 433 A (WILKINSON) 23. Mai 1978<br>* Spalte 3, Zeile 18 – Zeile 50; Abbildung 1 * | 5 | |
| A | EP 0 358 488 A (GEC ALSTHOM) 14. März 1990<br>* Zusammenfassung; Abbildungen 1-3 * | 1,3,5 | |
| A | JONGEPIER A G ET AL: "ADAPTIVE DISTANCE PROTECTION OF A DOUBLE-CIRCUIT LINE"<br>IEEE TRANSACTIONS ON POWER DELIVERY, Bd. 9, Nr. 3, 1. Juli 1994, Seiten 1289-1297, XP000484959<br>* Seite 1290, rechte Spalte * | 1,3,5 | RECHERCHIERTE SACHGEBIETE (Int.Cl.6)<br><br>G01R<br>H02H |

Der vorliegende Recherchenbericht wurde für alle Patentansprüche erstellt

| Recherchenort | Abschlußdatum der Recherche | Prüfer |
|---|---|---|
| DEN HAAG | 3. Mai 1999 | Iwansson, K |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**          EP 99 89 0031

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

03-05-1999

| Im Recherchenbericht angeführtes Patentdokument | | Datum der Veröffentlichung | Mitglied(er) der Patentfamilie | | | Datum der Veröffentlichung |
|---|---|---|---|---|---|---|
| EP 464662 | A | 08-01-1992 | SE | 466366 | B | 03-02-1992 |
| | | | CA | 2045884 | A | 30-12-1991 |
| | | | DE | 69114058 | D | 30-11-1995 |
| | | | DE | 69114058 | T | 20-06-1996 |
| | | | SE | 9002287 | A | 30-12-1991 |
| US 4091433 | A | 23-05-1978 | BR | 7800833 | A | 07-11-1978 |
| | | | DE | 2805094 | A | 17-08-1978 |
| | | | FR | 2385247 | A | 20-10-1978 |
| | | | GB | 1590665 | A | 03-06-1981 |
| | | | JP | 53109145 | A | 22-09-1978 |
| | | | SE | 7801595 | A | 11-08-1978 |
| | | | ZA | 7800080 | A | 29-11-1978 |
| EP 358488 | A | 14-03-1990 | GB | 2222688 | A | 14-03-1990 |
| | | | AU | 618843 | B | 09-01-1992 |
| | | | AU | 4114289 | A | 15-03-1990 |
| | | | CA | 1325826 | A | 04-01-1994 |
| | | | DE | 68916495 | D | 04-08-1994 |
| | | | DE | 68916495 | T | 13-10-1994 |
| | | | US | 5072403 | A | 10-12-1991 |

EPO FORM P0461

Für nähere Einzelheiten zu diesem Anhang : siehe Amtsblatt des Europäischen Patentamts, Nr.12/82